# EUROPEAN PATENT SPECIFICATION

(11) **EP 2 374 173 B1**
(45) Date of publication and mention of the grant of the patent: **01.04.2020**
(21) Application number: 09774998.0
(22) Date of filing: 13.10.2009
(51) Int. Cl.: H01L 21/56, H01L 51/52

(54) **METHOD FOR ENCAPSULATING ENVIRONMENTALLY SENSITIVE DEVICES**
VERFAHREN ZUM UMHÜLLEN EMPFINDLICHER BAUTEILE
PROCÉDÉ D'ENCAPSULATION DE DISPOSITIFS SENSIBLES À L'ENVIRONNEMENT

(30) Priority: 30.12.2008 US 345717
(43) Date of publication of application: 12.10.2011
(73) Proprietor: Samsung Display Co., Ltd., Gyeonggi-do (KR)
(72) Inventor: CHU, Xi, Fremont, CA 94538 (US); SUEN, Chyi-Shan, Sunnyvale, CA 94089 (US); VISSER, Robert, Jan, Menlo Park, CA 94025 (US)
(74) Representative: Mounteney, Simon James
(86) International application number: PCT/US2009/060437
(87) International publication number: WO 2010/077412

(56) References cited:
- WO-A1-2008/144080
- US-A- 3 496 427
- US-A1- 2004 021 416
- US-A1- 2004 187 999
- US-A1- 2005 224 935

## Description

There is a need for versatile visual display devices for electronic products of many different types. Many different display devices are presently being used, including organic light emitting devices (OLEDs), liquid crystal displays (LCDs), light emitting diodes (LEDs), light emitting polymers (LEPs), electronic signage using electrophoretic inks, electroluminescent devices (EDs), and phosphorescent devices. Many of these display devices are environmentally sensitive. Furthermore, other electronic devices, such as microelectronic devices, including integrated circuits, charge coupled devices, metal sensor pads, micro-disk lasers, electrochromic devices, photochromic devices, microelectromechanical systems (MEMS), organic and inorganic photovoltaic devices, thin film batteries, thin film devices with vias, Electro-Optic Polymer Modulators, and the like are also environmentally sensitive. As used herein, the term environmentally sensitive device means devices which are subject to degradation caused by permeation of environmental gases or liquids, such as oxygen and water vapor in the atmosphere or chemicals used in the processing of the electronic product.

As a result, these devices are often fabricated on glass substrates with glass, metal, or ceramic covers on top of the device with the edges sealed with an adhesive. However, it is well-known that the adhesive itself can be permeable to moisture and/or oxygen. Thus, over time, moisture and/or oxygen (or other contaminants) can diffuse through the adhesive and damage the device.

Vacuum insulation panels also need protection from ambient conditions. Vacuum insulation panels utilize the superior insulation properties of a vacuum. The core material provides structure to withstand pressure, but not to transfer heat. The core is encapsulated in a gas impermeable "membrane" barrier envelope, which is then evacuated and sealed to form the vacuum insulated panel or other shape. The panels can include desiccants and/or getter materials to absorb gases and moisture that permeate through the membrane. Multilayer plastic laminates require more desiccant and getter material. The long term performance of the vacuum insulation panels is highly dependent on the performance of the encapsulation material.

For completeness, background art includes: US2004021416, relating to an organic light emitting device with improved moisture seal, the device including first and second electrodes and a seal having layers of epoxy and alternating with layers of SiNH preventing water and oxygen from reaching the second electrode; US2005224935, relating to organic electronic packages having hermetically sealed edges to protect completely an organic electronic device from external elements, where a sealant may be implemented to surround completely the organic electronic device, or where edge wraps may be provided to surround completely the organic electronic device; and WO2008144080, relating to organic electronic devices protected by elastomeric laminating adhesive, where the adhesive adheres to a substrate and cover of the electronic device and encloses and protects an active organic component within the device.

Therefore, there is a need to provide a method of sealing an environmentally sensitive device which protects the adhesive from environmental gases and liquids according to claim 1. Any embodiment not comprising all the features of one claims 1 or 14 does not pertain to the invention.
Fig. 1 shows an example of a device useful for understanding the invention that can be made using the method of the present invention.
Fig. 2 shows another embodiment of a device that can be made using the method of the present invention.
Fig. 3 shows an example of a device useful for understanding the invention that can be made using the method of the present invention.
Fig. 4A shows another embodiment of a device that can be made using the method of the present invention.
Fig. 4B shows another an example of a device useful for understanding the invention that can be made using the method of the present invention.
Fig. 5 shows another embodiment of a device that can be made using the method of the present invention.
Fig. 6 shows another embodiment of a device that can be made using the method of the present invention.
Fig. 7 shows another embodiment of a device that can be made using the method of the present invention.
Fig, 8 shows another embodiment of a device that can be made using the method of the present invention.
Fig. 9 shows one embodiment of a vacuum insulation panel that can be made using the method of the present invention.

A first aspect of the present invention meets that need by providing a method of sealing an environmentally sensitive device as set out in Claim 1.

By adjacent, we mean next to, but not necessarily directly next to. There can be additional layers intervening between the substrate and the barrier stacks, and between the barrier stacks and the environmentally sensitive device.

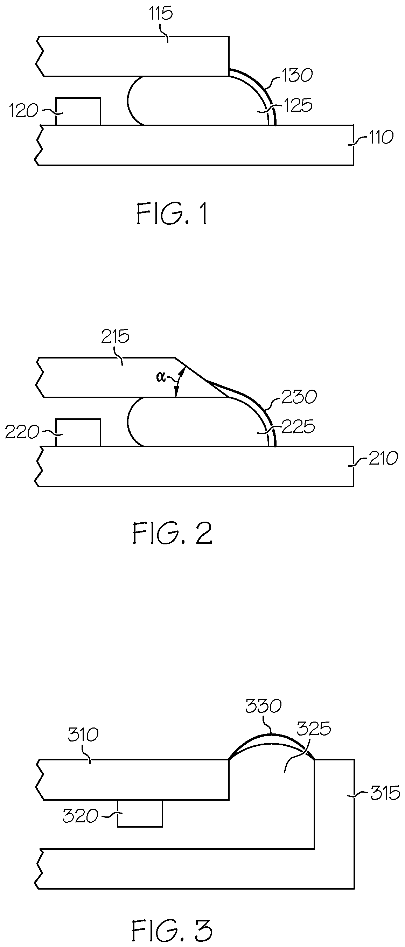

Fig. 1 shows one example of a device useful for understanding the invention. There are first and second substrates 110, 115. The substrates can be any type of substrates useful for the application. They can be either rigid or flexible. The substrates can be transparent, translucent, or opaque, depending on the application. Typically, at least one of the substrates is transparent, and both can be transparent if desired. Suitable substrates include, but are not limited to: metals and metal foils; glass, including thin, flexible, glass sheet (for example, flexible glass sheet available from Corning Inc. under the glass code 0211. This particular thin, flexible glass sheet has a thickness of less than 0.6 mm and will bend at a radium of about 8 inches.); ceramics; semiconductors; silicon; plastic films with barrier coatings; and combinations thereof.

An environmentally sensitive device is placed adjacent to the first substrate 110. The environmentally sensitive device can be any device requiring protection from moisture, gas, or other contaminants. Environmentally sensitive devices include, but are not limited to, organic light emitting devices, liquid crystal displays, displays using electrophoretic inks, light emitting diodes, light emitting polymers, electroluminescent devices, phosphorescent devices, organic and inorganic photovoltaic devices, thin film batteries, and thin film devices with vias, integrated circuits, charge coupled devices, metal sensor pads, micro-disk lasers, electrochromic devices, photochromic devices, microelectromechanical systems (MEMS), Electra-Optic Polymer Modulators, and combinations thereof.

The second substrate 115 is placed adjacent to the environmentally sensitive device 120. The first and second substrates 110, 115 are sealed together with an adhesive 125, sealing the environmentally sensitive device 120 between them. The adhesive 125 extends beyond the second substrate 115, exposing a portion of the adhesive 125 to ambient conditions. The adhesive 125 is then covered with a barrier stack 130. The barrier stack 130 includes at least one decoupling layer and at least one barrier layer.

Although Fig. 1 illustrates the adhesive extending beyond the second substrate, other situations are possible. Protection will be needed whenever the adhesive is exposed to ambient conditions.

The decoupling layer decouples defects between adjacent layers and/or the substrate, The processes used to deposit the barrier layers tend to reproduce any defects in the layer they are deposited on. Therefore, defects in or on the substrate or previous layer may be replicated in the deposited barrier layer, which can seriously limit the barrier performance of the films. The decoupling layer interrupts the propagation of defects from one layer to the next. This is achieved by reducing the surface imperfections of the substrate or previous layer, so that the subsequently deposited barrier layer or other layer, such as the organic light emitting device, has fewer defects. Thus, the decoupling layer has improved surface planarity compared to the previous layer. In addition, the decoupling layers decouple defects in the barrier layers. The decoupling layer intervenes between barrier layers so that the defects in one layer are not next to the defects in the subsequent layer. This creates a tortuous path for gas diffusion, helping to improve the barrier properties. A decoupling layer which is deposited over the barrier layer may also help to protect the barrier layer from damage during processing or further handling.

The decoupling layers can be deposited using a vacuum process, such as flash evaporation with *in situ* polymerization under vacuum, or plasma deposition and polymerization, or atmospheric processes, such as spin coating, ink jet printing, screen printing, or spraying. The decoupling layer can be made of any suitable decoupling material, including, but not limited to, organic polymers, inorganic polymers, organometallic polymers, hybrid organic/inorganic polymer systems, and combinations thereof. Organic polymers include, but are not limited to, urethanes, polyamides, polyimides, polybutylenes, isobutylene isoprene, polyolefins, epoxies, parylenes, benzocyclobutadiene, polynorbornenes, polyarylethers, polycarbonates, alkyds, polyaniline, ethylene vinyl acetate, ethylene acrylic acid, and combinations thereof. Inorganic polymers include, but are not limited to, silicones, polyphosphazenes, polysilazanes, polycarbosilanes, polycarboranes, carborane siloxanes, polysilanes, phosphonitriles, sulfur nitride polymers, siloxanes, and combinations thereof. Organometallic polymers include, but are not limited to, organometallic polymers of main group metals, transition metals, and lanthanide/actinide metals, or combinations thereof. Hybrid organic/inorganic polymer systems include, but are not limited to, organically modified silicates, preceramic polymers, polyimide-silica hybrids, (meth)acrylate-silica hybrids, polydimethylsiloxane-silica hybrids, and combinations thereof.

The barrier layers can be deposited using a vacuum process, such as sputtering, physical vapor deposition (PVD), chemical vapor deposition (CVD), metalorganic chemical vapor deposition (MOCVD), plasma enhanced chemical vapor deposition (PECVD), atomic layer deposition (ALD), evaporation, sublimation, electron cyclotron resonance-plasma enhanced vapor deposition (ECR-PECVD), and combinations thereof. The barrier layers are made of inorganic materials based on metals which include, but are not limited to, individual metals, two or more metals as mixtures, inter-metallics or alloys, metal and mixed metal oxides, metal and mixed metal fluorides, metal and mixed metal nitrides, metal and mixed metal carbides, metal and mixed metal carbonitrides, metal and mixed metal oxynitrides, metal and mixed metal borides, metal and mixed metal oxyborides, metal and mixed metal silicides, or combinations thereof. Metals include, but are not limited to, transition ("d" block) metals, lanthanide ("f" block) metals, aluminum, indium, germanium, tin, antimony and bismuth, and combinations thereof. Many of the resultant metal based materials will be conductors or semiconductors. The fluorides and oxides will include dielectrics (insulators), semiconductors and metallic conductors. Non-limiting examples of conductive oxides include aluminum doped zinc oxide, indium tin oxide (ITO), antimony tin oxide, titanium oxides (TiOₓ where 0.8 ≤ x ≤ 1) and tungsten oxides (WOₓ where 2.7 ≤ x < 3.0). Suitable inorganic materials based on p block semiconductors and non-metals include, but are not limited to, silicon, silicon compounds, boron, boron compounds, carbon compounds including amorphous carbon and diamond-like carbon, and combinations of. Silicon compounds include, but are not limited to silicon oxides (SiOₓ where 1 ≤ x ≤ 2), polysilicic acids, alkali and alkaline earth silicates, aluminosilicates (AlₓSiO_{y}), silicon nitrides (SNₓH_{y} where 0 ≤ y < 1), silicon oxynitrides (SiNₓO_{y}H_{z} where 0 ≤ z < 1), silicon carbides (SiCₓH_{y} where 0 ≤ y < 1), and silicon aluminum oxynitrides (SIALONs). Boron compounds include, but are not limited to, boron carbides, boron nitrides, boron oxynitrides, boron carbonitrides, and combinations thereof with silicon.

Suitable decoupling layers and barrier layers and methods of making them are described in U.S. Patent Nos. 6,268,695, entitled "Environmental Barrier Material For Organic Light Emitting Device And Method Of Making," issued July 31, 2001; 6,522,067, entitled "Environmental Barrier Material For Organic Light Emitting Device And Method Of Making," issued February 18, 2003; 6,570,325, entitled "Environmental Barrier Material For Organic Light Emitting Device And Method Of Making", issued May 27, 2003; RE 40531, entitled Ultrabarrier Substrates, issued October 7, 2008; 6,866,901, entitled Method for Edge Sealing Barrier Films, issued March 15, 2005; 7,198,832, entitled Method for Edge Sealing Barrier Films, issued April 3, 2007; Application Serial No. 11/068,356, entitled Method for Edge Sealing Barrier Films, filed February 28, 2005; Application Serial No. 11/693,020, entitled Method for Edge Sealing Barrier Films, filed March 29, 2007; and Application Serial No. 11/693,022, entitled Method for Edge Sealing Barrier Films, filed March 29, 2007.

The number of barrier stacks is not limited. The number of barrier stacks needed depends on the level of permeation resistance needed for the particular application. One or two barrier stacks may provide sufficient barrier properties for some applications. The most stringent applications may require five or more barrier stacks.

The barrier stacks have more than one decoupling layers and more than one barrier layers. There could be one decoupling layer and one barrier layer, there could be one or more decoupling layers on one side of one or more barrier layers, there could be one or more decoupling layers on both sides of one or more barrier layers, or there could be one or more barrier layers on both sides of one or more decoupling layers. The important feature is that the barrier stack have at least more than one decoupling layer and at least more than one barrier layer. The barrier layers in the barrier stacks can be made of the same material or of a different material, as can the decoupling layers.

In a multilayer stack, the barrier layers are typically about 100 to about 2000 Å thick. The initial barrier layer can be thicker than later barrier layers, if desired. For example, the first barrier layer might be in the range of about 1000 to about 1500 Å, while later barrier layers might be about 400 to about 500 Å. In other situations, the first barrier layer might be thinner than later barrier layers. For example, the first barrier layer might be in the range of about 100 to about 400 Å, while later barrier layers might be about 400 to about 500 Å. In some cases, for example when the barrier layer is deposited by PECVD, even thicker barrier layers are typically used, e.g., up to about 1-2 µm. In some cases, thicker barrier layers cannot be used with flexible substrates. However, with rigid substrates, flexibility of the barrier layer is not required.

The decoupling layers are typically about 0.1 to about 10 µm thick. The first decoupling layer can be thicker than later decoupling layers, if desired. For example, the first decoupling layer might be in the range of about 3 to about 5 µm, while later decoupling layers might be about 0.1 to about 2 µm.

The barrier stacks can have the same or different layers, and the layers can be in the same or different sequences.

The barrier stack can be deposited adjacent to the adhesive using the processes described above. Alternatively, the barrier stack can be deposited on a substrate and laminated adjacent to the adhesive. The barrier stack can be laminated by heating, soldering, using an adhesive, ultrasonic welding, applying pressure, or other known method.

A single barrier layer typically ranges in thickness from abut 100 Å to about 1-2 µm, depending on the process used.

Although the adhesive is shown in the figures as forming a convex shape, this is not necessary. It could form a concave shape, it could be flat, or it could form some other shape, depending on the amount, and type of adhesive, and application method used.

Suitable adhesives for vacuum include, but are not limited to two part systems; e.g., epoxies and urethanes, UV (ultraviolet) or EB (electron beam) curable based on acrylate and /or methacrylate functional precursors, thermoplastic adhesives, often called hot melts or heat activated, and pressure sensitive adhesives. These are typically applied as 100% solid systems that cure via addition mechanisms and so avoid issues associated with volatile reaction byproducts in a vacuum environment. Suitable adhesives can also be applied by routine atmospheric processes; i.e., casting layers from carriers, typically solvents or water that is then removed (dried). The resulting "dried" adhesive can be a pressure sensitive that bonds with contact, a thermoplastic activated by heat when thermally reversible bonding is adequate or a thermoset also activated by heat when irreversible bonding is required; i.e., use in high operating temperature environments. Thermoplastic adhesives can also be applied as fluids at elevated temperatures, cooled (frozen) to a solid state at ambient temperatures and then activated by reheating. Moisture cure (moisture exposure activated) adhesives useful in atmospheric environments include, but are not limited to moisture cure urethanes, RTV silicones and cyanoacrylates. Suitable adhesive application methods include, but are not limited to aforementioned casting, extrusion coating, ink jet printing, transfer (lamination) from a temporary support (release liner), and injection. The last mentioned is useful for more reactive two part systems or highly reactive catalyzed systems, and is designed such that in each component is supplied from separate sources to common mixing chamber just prior to application.

Fig. 2 shows the invention with the environmentally sensitive device 220 positioned between the first and second substrates 210, 215. The glue 225 is covered with a barrier stack 230. The edge of the second substrate 215 forms an angle a, which is less than 90° (as shown in Fig.1). The smaller angle allows better coverage of the adhesive during deposition.

Fig. 3 shows an example useful for understanding the invention. In this example, there is an environmentally sensitive device 320 adjacent to the first substrate 310, which is flat. The second substrate 315 is C-shaped. The second substrate is filled with adhesive 325. The adhesive is then covered with the barrier stack 330. Alternatively, the environmentally sensitive device could be adjacent to the C-shaped substrate, which would then be filled with adhesive, and the other substrate adhered to it.

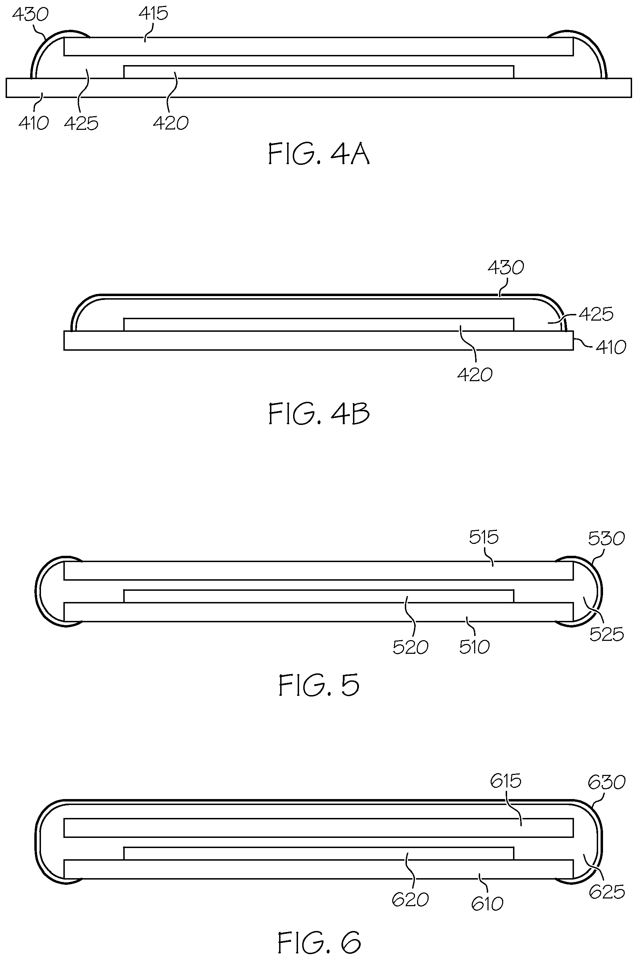

Fig. 4A shows an embodiment in which there are first and second substrates 410, 415, with the second substrate 415 being shorter than the first substrate 410. The environmentally sensitive device 420 is adjacent to the first substrate 410. The adhesive 425 fills the space between the first and second substrates 410, 415, and covers the environmentally sensitive device 420. The edge of the adhesive 425 is exposed beyond the end of the second substrate 415. The barrier stack 430 covers the exposed adhesive at both ends.

Fig. 4B shows an example useful for understanding the invention in which there is a first substrate 410 with an environmentally sensitive device 420 is adjacent to the first substrate 410. The adhesive 425 covers the environmentally sensitive device 420. The upper surface of the adhesive 425 is exposed. The barrier stack 430 covers the exposed adhesive 425. The barrier stack 430 can be applied to adhesive 425 before or after the adhesive is applied to cover the environmentally sensitive device 420. If the barrier stack is applied to the adhesive 425 before the adhesive is applied to the environmentally sensitive device, the adhesive 425 can act as a carrier film for the barrier stack 430).

Fig. 5 shows an embodiment in which the environmentally sensitive device 520 is between flat first and second substrates 510, 515. The first and second substrates 510, 515 are approximately the same length in this embodiment. The adhesive 525 fills the space between the first and second substrates 510, 515, and covers the environmentally sensitive device 520. The adhesive 525 is exposed at both ends of the substrates. The adhesive 525 is covered with a barrier stack 530.

Fig. 6 shows an embodiment in which the environmentally sensitive device 620 is between the first and second substrates 610, 615. The adhesive 625 fills the space between the first and second substrates 610, 615 and covers the top of the second substrate 615. The exposed adhesive 625 is covered with a barrier stack 630 which extends around the ends of the first and second substrates 610, 615 and covers the top of the second substrate 615.

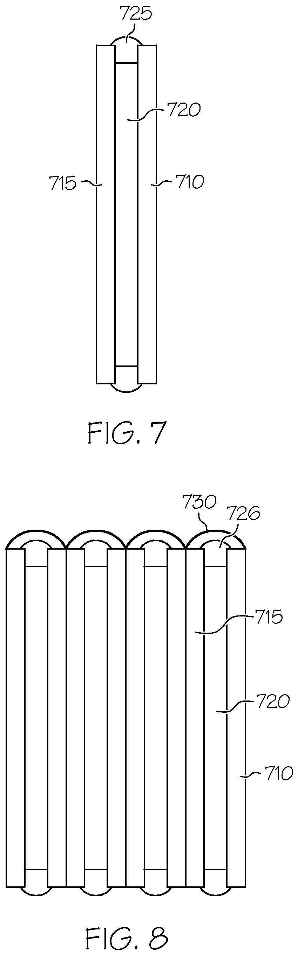

Figs. 7-8 show an example of an display, such as OLED. The OLED 720 is between flat first and second substrates and sealed with adhesive 725.

Several such units can be assembled into a display. The units can be placed adjacent to one another. The adhesive for all of the units can then be covered with the barrier stack at the same time, as shown in Fig. 8. This would allow tiling of pixels/displays to create bigger displays.

The adhesive used in each of the units can be the same or it can be different, if desired.

The first and second substrates can be a single piece of material folded over, or two separate pieces of material. The single piece of material can be folded over and sealed along two sides (or one side and the bottom). The two separate pieces of material can be sealed along both sides and the bottom. The seal can be formed by heat sealing or by sealing with an adhesive. If an adhesive is used, the adhesive can be covered with a barrier stack, if desired. The adhesive used to seal the opening and the sides can be the same or different, if desired.

When a liquid device, such as a liquid crystal display or an electrophoretic ink, is used in the device, edges of the substrates are sealed leaving a space between them, and an opening is left in the seal. The liquid is introduced into the opening in the seal, and the opening is sealed, producing the device. The substrates can be a single piece of material or two separate pieces, as described above. At least one of the sides is sealed, as described above, and an opening is left in the seal on one of the sides before the liquid is introduced. The opening in the side is then sealed with the adhesive, and the adhesive is covered with the barrier stack, as described above.

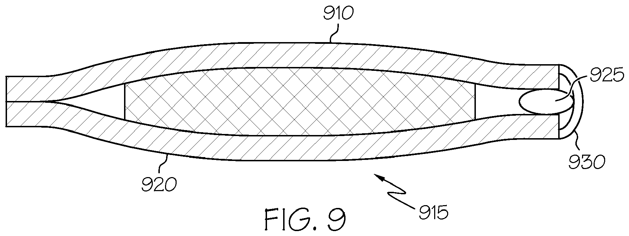

Another embodiment shows a vacuum insulating panel that can be made using the method of the present invention. As shown in Fig. 9, there are first and second substrates 910, and 915.

The first and second substrates 910, 915 form an envelope surrounding the core material 920. The envelope has an opening in one side. The opening can cover part of the side or the whole side. The gas is evacuated from the envelope forming a vacuum, and the opening of the envelope is then sealed with an adhesive 925. The adhesive 925 is covered with a barrier stack 930, as described above.

The envelope can be formed by sealing a single piece of material folded over along two sides (or one side and the bottom), or by sealing two separate pieces of material along both sides and the bottom. The seal used to make the envelope can be formed by heat sealing or by sealing with an adhesive. If the envelope is formed using an adhesive, the adhesive can be covered with a barrier stack, if desired.

Suitable substrates for the vacuum insulation panels include, but are not limited to, polyethylene (PE), polyethylene terephthalate (PET), polyethylene naphthalate (PEN), polyimide (PI), substrates having one or more barrier stacks thereon, or combinations thereof.

The adhesive used to seal the opening in the envelope and that used to form the envelope can be the same or different, if desired.

The barrier stack can be deposited so that it covers all or part of the surface of one or both substrates, if desired. This will provide additional protection for the vacuum insulation panel.

The envelope can be formed from the substrates before or after the core material is placed between them.

While certain representative embodiments and details have been shown for purposes of illustrating the invention, it will be apparent to those skilled in the art that various changes in the compositions and methods disclosed herein may be made without departing from the scope of the invention, which is defined in the appended claims.

## Claims

1. A method of sealing a device (225) which is subject to degradation caused by permeation of environmental gases or liquids comprising:
providing a first (210) substrate and a second substrate (215) thereon;
placing the device (225) between the first and second substrates (210, 215);
sealing the first and second substrates (210, 215) together with an adhesive (225), the adhesive (225) having an exposed portion;
wherein an edge of the second substrate (215) has an angle of less than 90°, and covering the exposed portion of the adhesive (225) and the edge part of the second substrate, for better coverage of the adhesive during deposition, with a barrier stack (230) comprising more than one decoupling layer and more than one barrier layer,
wherein the barrier layer is made of an inorganic material based on a metal, and wherein the decoupling layer is made of at least one decoupling material selected from the group consisting of organic polymers, inorganic polymers, organometallic polymers, hybrid organic/inorganic polymer systems, and combinations thereof.

2. A method according to claim 1 wherein at least one of the first or second substrates (210, 215) is flat.

3. A method according claim 1 wherein covering the exposed portion of the adhesive (225) with the bather stack comprises vacuum depositing the barrier stack adjacent to the adhesive (225).

4. A method according to claim 1 wherein the decoupling layer of the barrier stack (230) is deposited using an atmospheric process.

5. A method according to claim 1 wherein covering exposed portion of the adhesive (225) with the barrier stack (230) comprises depositing the barrier stack (230) on a flexible substrate, and laminating the flexible substrate with the barrier stack (230) adjacent to the adhesive.

6. A method according to claim 1 further comprising covering the first substrate (210) with the barrier stack (230).

7. A method according to claim 1 further comprising:
providing a third substrate;
placing a second device which is subject to degradation caused by permeation of environmental gases or liquids adjacent to the first substrate;
placing a fourth substrate adjacent to the second device;
sealing the third and fourth substrates together with a second adhesive, the second adhesive having an exposed portion;
placing the second-adhesive-covered third substrate, the second device, and the fourth substrate adjacent to the adhesive-covered first substrate (210), the device (220), and second substrate (215) before covering the adhesive (225) and the second adhesive with the barrier stack (230).

8. A method according to claim 1 wherein providing first and second substrates (210, 215) comprises providing a single piece of material and folding the single piece of material over.

9. A method according to claim 1 wherein providing first and second substrates (210, 215) comprises providing two separate pieces of material.

10. A method according to claim 1 wherein the first and second substrates (210, 215) are sealed on at least one side and wherein there is an opening in one side, and wherein the device (220) is placed between the first and second substrates (210, 215) after the first and second substrates (210, 215) are sealed on the at least one side, and wherein the opening in the one side is sealed with the adhesive after the device (220) is placed between the first and second substrates (210, 215).

11. A method according to claim 10 wherein the first and second substrates (210, 215) are sealed on the at least one side with a second adhesive, the second adhesive having an exposed portion, and further comprising covering the exposed portion of the second adhesive with a barrier stack (230) comprising at least one decoupling layer and at least one barrier layer.

12. An encapsulated display device comprising:
a first substrate (210);
a device (220) which is subject to degradation caused by permeation of environmental gases or liquids adjacent to the first substrate (210);
a second substrate (215) on the first substrate (210) and adjacent to the device (220);
an adhesive (225) sealing the first and second substrates (210, 215) together, the device (220) sealed between the first and second substrates (210, 215), the adhesive (225) having an exposed portion;
wherein an edge of the second substrate (215) has an angle of less than 90°; and
a barrier stack (230) comprising more than one decoupling layer and more than one barrier layer covering the exposed portion of the adhesive (225) and the edge part of the second substrate, for better coverage of the adhesive during deposition,
wherein the barrier layer is made of an inorganic material based on a metal, and
wherein the decoupling layer is made of at least one decoupling material selected from the group consisting of organic polymers, inorganic polymers, organometallic polymers, hybrid organic/inorganic polymer systems, and combinations thereof.

## Patentansprüche

1. Verfahren zum dichten Versiegeln einer Vorrichtung (225), welche Beschädigung aufgrund von Permeation von Gasen oder Flüssigkeiten aus der Umgebung unterliegt, Folgendes beinhaltend:
Bereitstellen eines ersten (210) Substrates und eines zweiten Substrates (215) daran;
Platzieren der Vorrichtung (225) zwischen dem ersten und dem zweiten Substrat (210, 215);
Zusammensiegeln das ersten und des zweiten Substrates (210, 215) mit einem Klebstoff (225), wobei der Klebstoff (225) einen exponierten Abschnitt aufweist;
wobei eine Kante des zweiten Substrates (215) einen Winkel unter 90° aufweist, welcher den exponierten Abschnitt des Klebstoffes (225) und den Kantenabschnitt des zweiten Substrates zur besseren Abdeckung des Klebstoffes im Zuge der Ablagerung mit einem Barrierestapel (230) bedeckt, welcher mehr als eine Entkopplungsschicht und mehr als eine Barriereschicht beinhaltet, wobei die Barriereschicht aus einem anorganischen Material besteht, basierend auf einem Metall, und wobei die Entkopplungsschicht aus mindestens einem Entkopplungsmaterial besteht, gewählt aus der Gruppe, bestehend aus organischen Polymeren, anorganischen Polymeren, organometallischen Polymeren, hybriden organischen/anorganischen Polymersystemen und Kombinationen daraus.

2. Verfahren nach Anspruch 1, bei welchem mindestens eines des ersten oder des zweiten Substrates (210, 215) flach ist.

3. Verfahren nach Anspruch 1, bei welchem Bedecken des exponierten Abschnittes des Klebstoffes (225) mit dem Barrierestapel das Vakuumablagern des Barrierestapels angrenzend an den Klebstoff (225) umfasst.

4. Verfahren nach Anspruch 1, bei welchem die Entkopplungsschicht des Barrierestapels (230) unter Verwendung eines atmosphärischen Prozesses erfolgt.

5. Verfahren nach Anspruch 1, bei welchem Bedecken des exponierten Abschnittes des Klebstoffes (225) mit dem Barrierestapel (230) Ablagern des Barrierestapels an einem flexiblen Substrat und Laminieren des flexiblen Substrates mit dem Barrierestapel (230) angrenzend an den Klebstoff beinhaltet.

6. Verfahren nach Anspruch 1, zusätzlich umfassend Bedecken des ersten Substrates (210) mit dem Barrierestapel (230).

7. Verfahren nach Anspruch 1, zudem beinhaltend:
Bereitstellen eines dritten Substrates;
Platzieren einer zweiten Vorrichtung, welche Beschädigung aufgrund von Permeation von Gasen oder Flüssigkeiten aus der Umgebung unterliegt, angrenzend an das erste Substrat;
Platzieren eines vierten Substrates angrenzend an die zweite Vorrichtung;
Zusammensiegeln des dritten und des vierten Substrates mit einem zweiten Klebstoff, wobei der zweite Klebstoff einen exponierten Abschnitt aufweist;
Platzieren des mit dem zweiten Klebstoff bedeckten dritten Substrates, der zweiten Vorrichtung und des vierten Substrates angrenzend an das mit Klebstoff bedeckte erste Substrat (210), die Vorrichtung (220) und das zweite Substrat (215) vor Bedecken des Klebstoffes (225) und des zweiten Klebstoffes mit dem Barrierestapel (230).

8. Verfahren nach Anspruch 1, bei welchem Bereitstellen des ersten und des zweiten Substrates (210, 215) Bereitstellen eines einzigen Materialstückes und Umfalten des einzigen Materialstückes beinhaltet.

9. Verfahren nach Anspruch 1, bei welchem Bereitstellen des ersten und des zweiten Substrates (210, 215) Bereitstellen zweier separater Materialstücke beinhaltet.

10. Verfahren nach Anspruch 1, bei welchem das erste und das zweite Substrat (210, 215) an mindestens einer Seite versiegelt sind und wobei in einer Seite eine Öffnung vorhanden ist, und wobei die Vorrichtung (220) zwischen dem ersten und dem zweiten Substrat (210, 215) platziert wird, nachdem das erste und das zweite Substrat (210, 215) an der mindestens einen Seite versiegelt wurden, und wobei die Öffnung in der einen Seite mit dem Klebstoff versiegelt wird, nachdem die Vorrichtung (220) zwischen dem ersten und dem zweiten Substrat (210, 215) platziert wurde.

11. Verfahren nach Anspruch 10, bei welchem das erste und das zweite Substrat (210, 215) an der mindestens einen Seite mit einem zweiten Klebstoff versiegelt werden, wobei der zweite Klebstoff einen exponierten Abschnitt aufweist, und zudem beinhaltend Bedecken des exponierten Abschnittes des zweiten Klebstoffes mit einem Barrierestapel (230), welcher mindestens eine Entkopplungsschicht und mindestens eine Barriereschicht beinhaltet.

12. Verkapselte Anzeigevorrichtung, Folgendes beinhaltend:
ein erstes Substrat (210);
eine Vorrichtung (220), welche Beschädigung aufgrund von Permeation von Gasen oder Flüssigkeiten aus der Umgebung unterliegt, angrenzend an das erste Substrat (210);
ein zweites Substrat (215) an dem ersten Substrat (210) und angrenzend an die Vorrichtung (220);
einen Klebstoff (225), welcher das erste und das zweite Substrat (210, 215) zusammensiegelt, wobei die Vorrichtung (220) zwischen dem ersten und dem zweiten Substrat (210, 215) versiegelt wird, wobei der Klebstoff (225) einen exponierten Abschnitt aufweist;
wobei eine Kante des zweiten Substrates (215) einen Winkel unter 90° aufweist; und einen Barrierestapel (230), welcher mehr als eine Entkopplungsschicht und mehr als eine Barriereschicht beinhaltet, welche den exponierten Abschnitt des Klebstoffes (225) und den Kantenabschnitt des zweiten Substrates zur besseren Abdeckung des Klebstoffes im Zuge der Ablagerung bedeckt,
wobei die Barriereschicht aus einem anorganischen Material besteht, basierend auf einem Metall, und
wobei die Entkopplungsschicht aus mindestens einem Entkopplungsmaterial besteht, gewählt aus der Gruppe, bestehend aus organischen Polymeren, anorganischen Polymeren, organometallischen Polymeren, hybriden organischen/anorganischen Polymersystemen und Kombinationen daraus.

## Revendications

1. Procédé d'encapsulation d'un dispositif (225) qui est soumis à une dégradation provoquée par la perméation de gaz ou liquides environnementaux comprenant :
la fourniture d'un premier substrat (210) et d'un deuxième substrat (215) pardessus ;
la mise en place du dispositif (225) entre le premier et le deuxième substrat (210, 215) ;
l'encapsulation du premier et deuxième substrat (210, 215) ensemble avec un adhésif (225), l'adhésif (225) présentant une partie exposée ;
dans lequel un bord du deuxième substrat (215) présente un angle inférieur à 90°, et couvrant la partie exposée de l'adhésif (225) et la partie de bord du deuxième substrat, pour une meilleure couverture de l'adhésif pendant la déposition, avec un empilement barrière (230) comprenant plusieurs couches de découplage et plusieurs couches barrières, dans lequel la couche barrière est constituée d'un matériau inorganique à base de métal, et dans lequel la couche de découplage est constituée d'au moins un matériau de découplage sélectionné dans le groupe constitué de polymères organiques, de polymères inorganiques, de polymères organométalliques, de systèmes polymères organiques/inorganiques hybrides, et de combinaisons de ceux-ci.

2. Procédé selon la revendication 1, dans lequel au moins un du premier ou du deuxième substrat (210, 215) est plat.

3. Procédé selon la revendication 1, dans lequel la couverture de la partie exposée de l'adhésif (225) avec l'empilement barrière comprend la déposition sous vide de l'empilement barrière à proximité de l'adhésif (225).

4. Procédé selon la revendication 1, dans lequel la couche de découplage de l'empilement barrière (230) est déposée en utilisant un processus atmosphérique.

5. Procédé selon la revendication 1, dans lequel la couverture de la partie exposée de l'adhésif (225) avec l'empilement barrière (230) comprend la déposition de l'empilement barrière (230) sur un substrat flexible, et la stratification du substrat flexible avec l'empilement barrière (230) à proximité de l'adhésif.

6. Procédé selon la revendication 1, comprenant en outre la couverture du premier substrat (210) avec l'empilement barrière (230).

7. Procédé selon la revendication 1, comprenant en outre :
la fourniture d'un troisième substrat ;
la mise en place d'un second dispositif qui est soumis à une dégradation provoquée par la perméation de gaz ou liquides environnementaux à proximité du premier substrat ;
la mise en place d'un quatrième substrat à proximité du second dispositif ;
l'encapsulation des troisième et quatrième substrats ensemble avec un second adhésif, le second adhésif présentant une partie exposée ;
la mise en place du troisième substrat recouvert d'un second adhésif, du second dispositif, et du quatrième substrat à proximité du premier substrat recouvert d'adhésif (210), au dispositif (220), et au deuxième substrat (215) avant de couvrir l'adhésif (225) et le second adhésif avec l'empilement barrière (230).

8. Procédé selon la revendication 1, dans lequel la fourniture du premier et deuxième substrat (210, 215) comprend la fourniture d'une pièce de matériau unique et le repli de la pièce de matériau unique.

9. Procédé selon la revendication 1, dans lequel la fourniture du premier et deuxième substrat (210, 215) comprend la fourniture de deux pièces de matériau séparées.

10. Procédé selon la revendication 1, dans lequel le premier et le deuxième substrat (210, 215) sont scellés sur au moins un côté et dans lequel il existe une ouverture d'un côté, et dans lequel le dispositif (220) est placé entre le premier et le deuxième substrat (210, 215) après que le premier et le deuxième substrat (210, 215) ont été encapsulés sur l'au moins un côté, et dans lequel l'ouverture d'un côté est scellée avec l'adhésif après que le dispositif (220) est placé entre le premier et le deuxième substrat (210, 215).

11. Procédé selon la revendication 10, dans lequel le premier et le deuxième substrat (210, 215) sont scellés sur l'au moins un côté avec un second adhésif, le second adhésif présentant une partie exposée, et comprenant en outre la couverture de la partie exposée du second adhésif avec un empilement barrière (230) comprenant au moins une couche de découplage et au moins une couche barrière.

12. Dispositif d'affichage encapsulé comprenant :
un premier substrat (210) ;
un dispositif (220) qui est soumis à une dégradation provoquée par la perméation de gaz ou de liquides environnementaux à proximité du premier substrat (210) ;
un deuxième substrat (215) sur le premier substrat (210) et adjacent au dispositif (220) ;
un adhésif (225) scellant le premier et le deuxième substrat (210, 215) ensemble, le dispositif (220) étant encapsulé entre le premier et le deuxième substrat (210, 215), l'adhésif (225) présentant une partie exposée ;
dans lequel un bord du deuxième substrat (215) présente un angle inférieur à 90° ; et
un empilement barrière (230) comprenant plusieurs couches de découplage et plusieurs couches barrière couvrant la partie exposée de l'adhésif (225) et la partie de bord du deuxième substrat, pour une meilleure couverture de l'adhésif pendant la déposition,
dans lequel la couche barrière est constituée d'un matériau inorganique à base de métal, et
dans lequel la couche de découplage est constituée d'au moins un matériau de découplage sélectionné dans le groupe constitué de polymères organiques, de polymères inorganiques, de polymères organométalliques, de systèmes polymères organiques/inorganiques hybrides et de combinaisons de ceux-ci.
